# EUROPEAN PATENT APPLICATION

(11) **EP 4 361 121 A1**
(43) Date of publication of application: **01.05.2024**
(21) Application number: 22852640.6
(22) Date of filing: 25.05.2022
(51) Int. Cl.: C04B 41/87, C04B 35/488, C04B 35/5835, C04B 35/596, H01L 21/683

(54) **WAFER SUPPORT**

(30) Priority: 06.08.2021 JP 2021129691
(71) Applicant: Ferrotec Material Technologies Corporation, Chuo-ku Tokyo 103-0027 (JP)
(72) Inventor: YAMAGISHI Wataru, Hakusan-City, Ishikawa 9240833 (JP); MORI Kazumasa, Hakusan-City, Ishikawa 9240833 (JP); KOUNO Hitoshi, Hakusan-City, Ishikawa 9240833 (JP); ETO Shunichi, Hakusan-City, Ishikawa 9240833 (JP)
(74) Representative: Isarpatent
(86) International application number: PCT/JP2022/021407
(87) International publication number: WO 2023/013211

(57) **Abstract**

A wafer support 10 includes a base material 14 including a machinable ceramic, a protective layer 16 covering a surface of the base material, and conductive members 18 and 20 placed at least partially inside the base material. The protective layer 16 includes a material that is less corrodible by plasma than the base material 14.

## Description

### Technical Field

The present invention relates to a support that supports a wafer.

### Background Art

Many of ceramic materials used for conventional electrostatic chucks and the like are fine ceramics difficult to process, such as silicon nitride and aluminum nitride, and complicated processing of them has been difficult from the viewpoint of cutting speed and chipping (defect). Therefore, a wafer support has been devised in which a machinable ceramic excellent in processability is used as a base material (see Patent Literature 1).

### Citation List

### Patent Literature

Patent Literature 1: JP 2020-155571 A

### Summary of Invention

### Technical Problem

However, if the above-described wafer support is exposed to a corrosive gas or a plasma atmosphere in a semiconductor manufacturing process, particles are easily generated from the surface. Adhesion of the particles to the wafer causes a fault in the subsequent semiconductor manufacturing process.

The present invention has been made in view of such a circumstance, and an object of the present invention is to provide a new wafer support excellent in corrosion resistance to plasma.

### Solution to Problem

In order to solve the above problem, a wafer support of an aspect of the present invention includes a base material including a machinable ceramic, a protective layer covering a surface of the base material, and a conductive member placed at least partially inside the base material. The protective layer includes a material that is less corrodible by plasma than the base material.

Machinable ceramics are easier to process than general fine ceramics. Therefore, according to this aspect, wafer supports having various shapes can be manufactured even if a complicated shape is not realized at the stage of preparing the base material, because processing can be performed after preparing the base material. In addition, according to this aspect, corrosion of the base material due to plasma can be reduced by the protective layer. Furthermore, even in a case where the base material includes a material that is likely to separate, separation can be reduced by the protective layer.

The protective layer may include at least one material selected from the group consisting of aluminum nitride (AlN), aluminum oxide (Al₂O₃), yttrium oxide (Y₂O₃), magnesium oxide (MgO), yttrium aluminum garnet (YAG: Y₃O₅Al₁₂), and yttrium aluminum monoclinic (YAM: Y₄Al₂O₉). As a result, corrosion of the base material due to plasma can be further reduced.

The protective layer may have a thickness in the range of 1 to 30 um. As a result, both a desired adsorption force and corrosion resistance to plasma can be achieved. If the thickness of the protective layer is preferably 2 µm or more and more preferably 5 um or more, further good corrosion resistance to plasma can be obtained. If the thickness of the protective layer is preferably 20 um or less and more preferably 10 µm or less, a further sufficient adsorption force can be obtained.

The protective layer may have an arithmetic mean height Sa in the range of 0.07 to 0.20 um. As a result, the protective layer can appropriately contact with the wafer to be supported.

The protective layer may include 99.0% or more of AlN. As a result, original corrosion resistance of AlN to plasma can be obtained.

The machinable ceramic may be a sintered body that includes at least two materials selected from the group consisting of boron nitride (BN), zirconium oxide (ZrO₂), silicon nitride (Si₃N₄), and silicon carbide (SiC) and essentially includes boron nitride. Boron nitride is excellent in machinability, and using a machinable ceramic including boron nitride as an essential component can increase the processing rate. In the case of a wafer support in which a conductive member as a different material is placed inside a base material, an internal stress is generated due to a temperature change according to a difference in physical properties between the base material and the conductive member. Alternatively, thermal stress is generated due to a temperature difference between the outer peripheral portion and the central portion of the wafer support. However, the base material is less likely to fracture because boron nitride has excellent thermal shock resistance.

The machinable ceramic may include 10 to 80 mass% of boron nitride, 0 to 80 mass% of silicon nitride, 0 to 80 mass% of zirconium oxide, and 0 to 40 mass% of silicon carbide with respect to 100 mass% of a total of ceramic components of boron nitride, zirconium oxide, silicon nitride, and silicon carbide. The machinable ceramic may further include 3 to 25 mass% of a sintering aid component with respect to 100 mass% of the total of the ceramic components.

The conductive member may include a metal material selected from the group consisting of molybdenum, tungsten, tantalum, and alloys containing molybdenum, tungsten, and tantalum.

Note that any combination of the above constituent elements and a modification of the expression of the present invention in methods, apparatuses, systems, and the like are also effective as aspects of the present invention. Furthermore, an appropriate combination of the above-described elements can also be included in the scope of the invention for which patent protection is sought by the present patent application.

### Advantageous Effects of Invention

According to the present invention, a new wafer support excellent in corrosion resistance to plasma can be realized.

### Brief Description of Drawings

FIG. 1 is a schematic sectional view of a wafer support according to the present embodiment.
FIG. 2 is a view showing a photograph of a section of a wafer support according to Example 1 taken with a scanning electron microscope (SEM).
FIG. 3A is a view showing a SEM photograph of a surface of a substrate of aluminum nitride, FIG. 3B is a view showing a SEM photograph of a surface of a substrate of a machinable ceramic, and FIG. 3C is a view showing a SEM photograph of a surface of a protective layer of a wafer support according to Example 1.
FIG. 4 is a schematic diagram for explanation of a plasma exposure test.

### Description of Embodiments

Hereinafter, embodiments of the present invention will be described in detail with reference to the drawings. In description of the drawings, the same element is denoted by the same reference sign, and redundant description will be omitted as appropriate.

### (Wafer Support)

A wafer support is to be capable of supporting a semiconductor substrate such as a silicon wafer, and may include an adsorption mechanism or a heating mechanism. For example, the wafer support may simply be a susceptor on which a wafer is mounted. Furthermore, the wafer support may be an electrostatic chuck that generates an adsorption force on a mounted wafer or a heater that heats the wafer. The object supported by the wafer support is mainly a wafer, but another member or component may be supported.

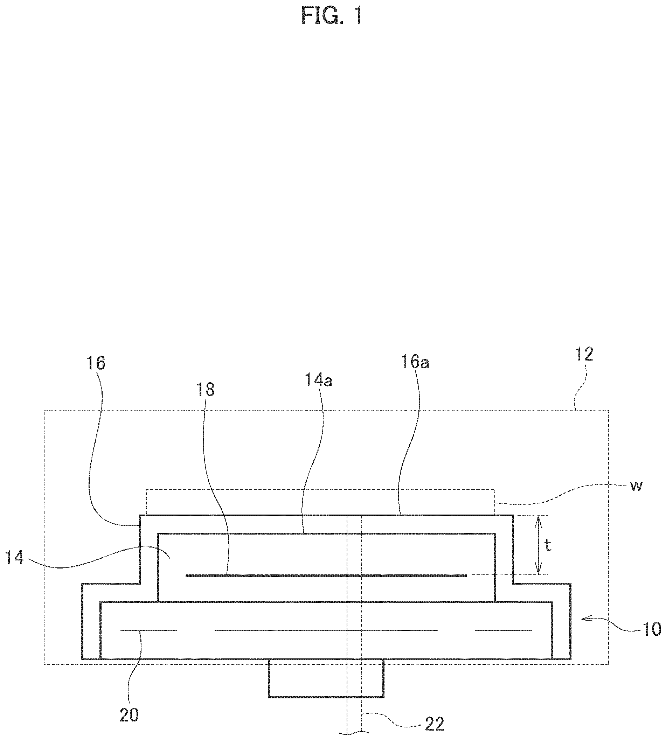

In the present embodiment, a case where the wafer support is an electrostatic chuck with a heater will be described as an example. FIG. 1 is a schematic sectional view of a wafer support according to the present embodiment.

A wafer support 10 according to the present embodiment is used for supporting a wafer W in a chamber 12 in an apparatus for semiconductor manufacturing such as plasma CVD. The wafer support 10 includes a base material 14 including a machinable ceramic, a protective layer 16 covering a surface 14a of the base material 14, and conductive members 18 and 20 placed at least partially inside the base material 14. The wafer W is mounted on a surface as a mounting surface 16a of the protective layer 16.

The conductive member 18 functions as an electrostatic chuck electrode through which a current flows that generates an adsorption force for fixing of the wafer W to the mounting surface 16a. The conductive member 20 functions as a resistance heating body (heater) for heating of the wafer W to a predetermined process temperature. In the wafer support 10 according to the present embodiment, the conductive members 18 and 20 are embedded in the base material 14 that is a sintered body. Therefore, the conductive members 18 and 20 are to be disposed inside a raw material powder at the stage of firing, and are preferably a high melting point metal that does not melt at the firing temperature. For example, the material of the conductive member is preferably a high melting point metal such as molybdenum, tungsten, or tantalum, or an alloy containing two or more kinds thereof.

In the wafer support 10, a gas inlet 22 may be formed that passes through the inside of the base material 14 from the mounting surface 16a exposed to the chamber side to a gas supply source (not illustrated) on the outside. The gas inlet 22 supplies a gas that cools the wafer W adsorbed on the mounting surface 16a from the back surface side.

### (Machinable Ceramic)

As a result of intensive studies to find a material suitable for the wafer support, the present inventor has found that a sintered body is preferable that includes a so-called machinable ceramic good in processability (having a free-cutting property).

Machinable ceramics are easier to machine than general fine ceramics such as aluminum oxide, silicon nitride, aluminum nitride, and silicon carbide. That is, in a machinable ceramic, defect called chipping, which is a problem in processing of the ceramic, is less likely to occur, and complicated processing is possible. Furthermore, the amount of a machinable ceramic ground at the time of processing (processing rate) is several times to several hundred times the amount of a fine ceramic ground at the time of processing, and thus efficient processing can be performed.

A machinable ceramic is a composite material in which a plurality of raw material compounds as ceramic components are mixed, and the volume resistivity can be adjusted by, for example, the blending ratio of silicon carbide. As a result, it is possible to cope with both the adsorption mechanisms of an electrostatic chuck of the Coulomb type and the Johnsen-Rahbek type. In the case of a heater, the machinable ceramic can be used as an insulator without adding silicon carbide. The machinable ceramic does not need to have a uniform composition as a whole, and the composition may be varied so that the function of each portion is optimized in the portion accommodating the conductive member 18 in the vicinity of the mounting surface 16a on which the wafer W is mounted and the portion accommodating the conductive member 20.

Furthermore, boron nitride as one of the main components has more excellent thermal shock resistance than typically used aluminum oxide, silicon nitride, aluminum nitride, and silicon carbide, and can prevent damage due to fracture when included in a wafer support as a product.

The machinable ceramic according to the present embodiment is a sintered body that includes at least two materials selected from the group consisting of boron nitride, zirconium oxide, silicon nitride, and silicon carbide and essentially includes boron nitride. Boron nitride is also excellent in machinability, and using the machinable ceramic including boron nitride as an essential component can increase the processing rate. In the case of a wafer support in which a conductive member as a different material is placed inside a base material, an internal stress is generated due to a temperature change according to a difference in physical properties between the base material and the conductive member. Alternatively, thermal stress is generated due to a temperature difference between the outer peripheral portion and the central portion of the wafer support. However, the base material is less likely to fracture because boron nitride has excellent thermal shock resistance.

The machinable ceramic according to the present embodiment is to include 10 to 80 mass% of boron nitride, 0 to 80 mass% of silicon nitride, 0 to 80 mass% of zirconium oxide, and 0 to 40 mass% of silicon carbide with respect to 100 mass% of a total of ceramic components of boron nitride, zirconium oxide, silicon nitride, and silicon carbide.

The machinable ceramic according to the present embodiment includes a sintering aid component. The sintering aid can be selected from those used for sintering silicon nitride and boron nitride. Preferred sintering aids are one or more obtained from aluminum oxide (alumina), magnesium oxide (magnesia), yttrium oxide (yttria), and oxides of lanthanoid metals. More preferred sintering aids are a mixture of alumina and yttria, the above-described mixture to which magnesia is further added, a mixture of yttria and magnesia, and the like.

The amount of the sintering aid component blended is desirably in the range of 1 to 25 mass%, particularly 3 to 25 mass% with respect to 100 mass% of the total of the ceramic components (not including the sintering aid component). If the amount of the sintering aid component blended is 1 mass% or more, preferably 3 mass% or more, the sintered body is easily densified, and lack of density and deterioration of a mechanical characteristic in the sintered body can be suppressed. Meanwhile, if the amount of the sintering aid component blended is 25 mass% or less, the grain boundary phase having low strength is reduced, so that deterioration of the mechanical strength and deterioration of the processability due to an increase in the grain boundary phase can be suppressed.

Boron nitride is excellent in machinability but poor in strength characteristics. Therefore, coarse boron nitride present in the sintered body becomes fracture origin to cause defect and fracture at the time of processing. For preventing formation of such coarse boron nitride particles, pulverizing a raw material powder is effective. A main raw material powder, particularly a raw material powder of boron nitride having an average particle size of less than 2 µm is desirably used. Boron nitride has a phase such as a hexagonal (h-BN) low-pressure phase or a cubic (c-BN) high-pressure phase, and hexagonal boron nitride is preferable from the viewpoint of a free-cutting property. From the viewpoint of processability, a larger amount of boron nitride and a smaller amount of silicon nitride (and zirconium oxide) are more preferable. Furthermore, the larger the amount of boron nitride is and the smaller the amount of silicon nitride (and zirconium oxide) is, the lower the mechanical strength and the Young's modulus are.

Examples of the machinable ceramic include a BN-containing silicon nitride-based ceramic ("Photoveel II" and "Photoveel II-k70", manufactured by Ferrotec Material Technologies Corporation). Photoveel II-k70 has a composition including 38.5 mass% of boron nitride, 54.1 mass% of silicon nitride, 5.5 mass% of yttria, and 1.9 mass% of magnesia. This BN-containing silicon nitride-based ceramic has a bending strength of 600 MPa or less, a Young's modulus of 250 GPa or less, and a Vickers hardness of 5 GPa or less. In using a machinable ceramic having such characteristics, the amount of the ceramic ground per unit time at the time of processing (processing rate) is large, and even a wafer support having a complicated shape can be efficiently produced. Furthermore, the base material is prepared as a block having a simple shape and then cut into a desired shape, and thus a complicated wafer support can be manufactured with one component.

### (Method of Manufacturing Sintered Body)

First, main raw material powders as ceramic components including boron nitride, zirconium oxide, silicon nitride, silicon carbide, and the like and 3 to 25 mass% of a sintering aid powder with respect to 100 mass% of the total of the ceramic components are mixed in accordance with the blending amounts in each of Examples and Comparative Examples described below to prepare a raw material powder. This mixing can be performed with, for example, a wet ball mill or the like.

Next, the raw material powder or the molded body, or both the raw material powder and the molded body are molded under high temperature and pressure, and fired to prepare a sintered body. A part of the raw material powder or the molded body may be replaced with a sintered body. In order to provide a resistance heating body for a heater and an electrode of an electrostatic chuck inside the sintered body, a member or a material to be a conductor after firing (such as a metal plate, a metal foil, a conductive paste, a coil, or a mesh) is to be disposed (embedded) at a predetermined position at the time of filling a hot press apparatus with the raw material powder, the molded body, or the sintered body. The shape of the conductor is not particularly limited. This firing can be performed using, for example, a hot press apparatus. The hot pressing is performed in a non-oxidizing (inert) atmosphere such as a nitrogen or argon atmosphere, or may be performed in pressurized nitrogen. The hot pressing temperature is, for example, in the range of 1300 to 1950°C. If the temperature is too low, sintering becomes insufficient, and if the temperature is too high, thermal decomposition of the main raw material occurs. The appropriate pressure is in the range of 20 to 50 MPa. The duration of the hot pressing depends on the temperature and dimensions, and is usually about 1 to 4 hours. The high temperature pressure sintering can also be performed by hot isostatic pressing (HIP). Sintering conditions in this case can also be appropriately set by those skilled in the art.

Then, the sintered body is processed into a desired shape to manufacture a wafer support. The machinable ceramic according to the present embodiment has high strength and high machinability (a free-cutting property), so that complicated fine processing can be performed in an industrially feasible time. Various conditions in manufacturing the sintered body are to be selected so that the machinable ceramic has an average crystal grain size of 0.5 um or less in consideration of corrosion resistance to plasma described below. As a result, even if a part of the polycrystal is separated as particles due to corrosion in a plasma atmosphere, the particles themselves are small, and thus faults in the semiconductor manufacturing process can be reduced. The average crystal grain size of the machinable ceramic is more preferably 0.1 um or less.

As described above, the machinable ceramic used in the base material 14 according to the present embodiment is easier to process than general fine ceramics. Therefore, according to this aspect, wafer supports having various shapes can be manufactured even if a complicated shape is not realized at the stage of preparing the base material 14, because processing can be performed after preparing the base material.

Meanwhile, the wafer support 10 is exposed to a corrosive gas or a plasma atmosphere in a semiconductor manufacturing process according to the use of the wafer support 10. Examples of the corrosive plasma include fluorine-based gases such as CF₄, C₄F₈, SF₈, NF₃, and CHF₃, and in addition, a gas such as Ar, O₂, or CO₂ may be mixed. The silicon component has high reactivity with fluorine-based plasma, and therefore a base material including silicon has low resistance to such plasma. Boron nitride has high reactivity with O₂ plasma.

As described above, the machinable ceramic according to the present embodiment may include silicon nitride, silicon carbide, and boron nitride as main components, and the inventor of the present application has conceived a possibility that the machinable ceramic including silicon and boron nitride has low corrosion resistance in a corrosive plasma atmosphere. Then, in order to improve the corrosion resistance of the wafer support to plasma, the protective layer 16 is provided on the surface of the base material 14 of the wafer support 10 according to the present embodiment.

### (Protective Layer)

The protective layer 16 according to the present embodiment includes a material that is less corrodible by plasma than the base material 14. As a result, corrosion of the base material 14 due to plasma can be reduced by the protective layer 16. Furthermore, even in a case where the base material 14 includes a material that is likely to separate, separation can be reduced by the protective layer 16. The protective layer 16 according to the present embodiment includes at least one material selected from the group consisting of aluminum nitride, aluminum oxide, yttrium oxide, magnesium oxide, yttrium aluminum garnet (YAG: Y₃O₅Al₁₂), and yttrium aluminum monoclinic (YAM: Y₄Al₂O₉). Aluminum nitride is particularly excellent in thermal shock resistance, and therefore is a suitable material in a process in which a high thermal shock is applied to an electrostatic chuck.

As illustrated in FIG. 1, the thickness between the mounting surface 16a, which is the surface of the protective layer 16, and the conductive member 18 is the thickness t of the dielectric layer. Therefore, if the film thickness of the protective layer 16 is too large, the thickness t of the dielectric layer is too large to obtain a sufficient adsorption force. If the thickness t is too large, a crack is likely to occur in the protective layer 16 when a high thermal shock is applied. Meanwhile, if the thickness t of the protective layer 16 is too small, sufficient corrosion resistance to plasma cannot be obtained. Therefore, the protective layer 16 according to the present embodiment has a thickness in the range of 1 to 30 um. As a result, both a desired adsorption force and corrosion resistance to plasma can be achieved. If the thickness of the protective layer 16 is preferably 2 µm or more and more preferably 5 um or more, further good corrosion resistance to plasma can be obtained. If the thickness of the protective layer 16 is preferably 20 um or less and more preferably 10 µm or less, a further sufficient adsorption force can be obtained.

### (Method of Forming Protective Layer)

The protective layer is formed with, for example, a method such as CVD, PVD (sputtering or ion plating), or aerosol deposition. These methods are excellent in film thickness control, and therefore a film having a thickness in the range of 1 to 30 um can be formed with high accuracy like the above-described protective layer.

In sputtering, a substrate and a target (material to be a film) are made opposite to each other, a negative high voltage is applied to the target to cause discharge in an Ar gas atmosphere of about 10⁻¹ to several Pa, and Ar ions are collided with the target. When Ar ions are collided with the target, a sputtering phenomenon occurs in which atoms are ejected from the target. The ejected atoms are deposited on the base material to form a protective layer.

For forming the protective layer 16 according to the present embodiment, a reactive sputtering method is suitable. It is known that in the case of using a compound such as aluminum oxide or aluminum nitride as a target, the sputtering rate is remarkably reduced to reduce the coating rate extremely and a film is formed that has a composition deviated from that of the target because each element has a different sputtering rate. Therefore, in a case where the constituent material of the protective layer according to the present embodiment is aluminum nitride, a reactive sputtering method is suitable in which a single metal aluminum target is used and reacted with N₂ as a reactive gas.

Ion plating, which is another method of forming a protective layer, is a method in which a substrate and an evaporation source (material to be a film) are made opposite to each other and a raw material of a film is dissolved and evaporated from the evaporation source in a vacuum of about 10⁻² to 10⁻⁴ Pa and thus deposited on the substrate. Films of various materials depending on the kind of the material to be evaporated can be prepared by introduction of a reaction gas. In coating technology based on vacuum deposition, general methods using ions are called ion plating. Specifically, ion plating includes various methods such as radio-frequency ion plating, reactive ion plating, and ion-assisted deposition, and any method can be used. In a case where the constituent material of the protective layer according to the present embodiment is yttrium oxide, a film can be formed in a plasma atmosphere by using metal yttrium as a vapor deposition source and introducing O₂ into the reaction gas. In the case of ion-assisted deposition, a protective layer including yttrium oxide as a constituent material can be formed by using yttrium oxide as a vapor deposition source and O₂ ions as assist ions. Also in the case of a protective layer including magnesium oxide or aluminum oxide as a constituent material, a film can be formed by radio-frequency ion plating, reactive ion plating, or ion-assisted deposition.

In the case of a method of forming a film using ions, such as sputtering or ion plating described above, the surface can be cleaned with Ar ions (a surface deposit or an oxide film can be removed by ion impact) before film formation, so that a film having high adhesion can be obtained. N₂ ions and H₂ ions are particularly effective for cleaning an organic substance (a step generally called ion bombardment). The bombardment step can remove ultrafine particles (those that cannot be removed by ultrasonic cleaning or the like) on the surface of the machinable ceramic as the base material, and thus in the base material including the protective film, generation of particles at an initial stage can be reduced as compared with the base material including no protective film. In these methods, the purity of aluminum nitride can also be higher than in a bulk ceramic produced by baking and solidifying a powder, and therefore the possibility of wafer contamination is reduced to contribute to reduction of faults.

If the base material including the machinable ceramic has a surface roughness in a predetermined range (for example, an arithmetic mean roughness Ra in the range of 0.02 um ≤ Ra ≤ 0.2 µm), the electrostatic chuck using the base material comes into point contact with the wafer, and thus is less likely to rub against the wafer during dechucking. Meanwhile, the cleavage property of boron nitride is likely to cause separation of particles (crack) by a physical force, and therefore particles are likely to be generated as they are. However, if the surface of the base material 14 is coated with the protective layer 16 such as aluminum nitride described above, separation of particles is reduced, and generation of particles can be reduced. In addition, the protective layer 16 prepared with the film forming method according to the present embodiment follows the surface roughness of the base material 14, and has a surface having an arithmetic mean roughness Ra in the range of 0.02 µm ≤ Ra ≤ 0.2 um. That is, the protective layer 16 having corrosion resistance to plasma is included, and in addition, the protective layer 16 itself can be in point contact with the wafer, and therefore the wafer support 10 according to the present embodiment is extremely excellent in reducing particles.

In the case of a multilayer member in which each layer includes a hard material (combination of materials having a high Young's modulus), all of the layers are less likely to deform, and thus a crack easily occurs due to a thermal stress or the like. However, the stress can be absorbed (relaxed) by using the base material 14 including boron nitride as a main component as in the wafer support 10 according to the present embodiment. Furthermore, since the machinable ceramic according to the present embodiment is a composite material, the thermal expansion coefficient of the base material 14 can be matched with the thermal expansion coefficient of the protective layer 16. As a result, the thermal stress due to difference in the thermal expansion coefficient of each layer can be reduced, and occurrence of a crack, that is, generation of particles is suppressed.

### [Examples]

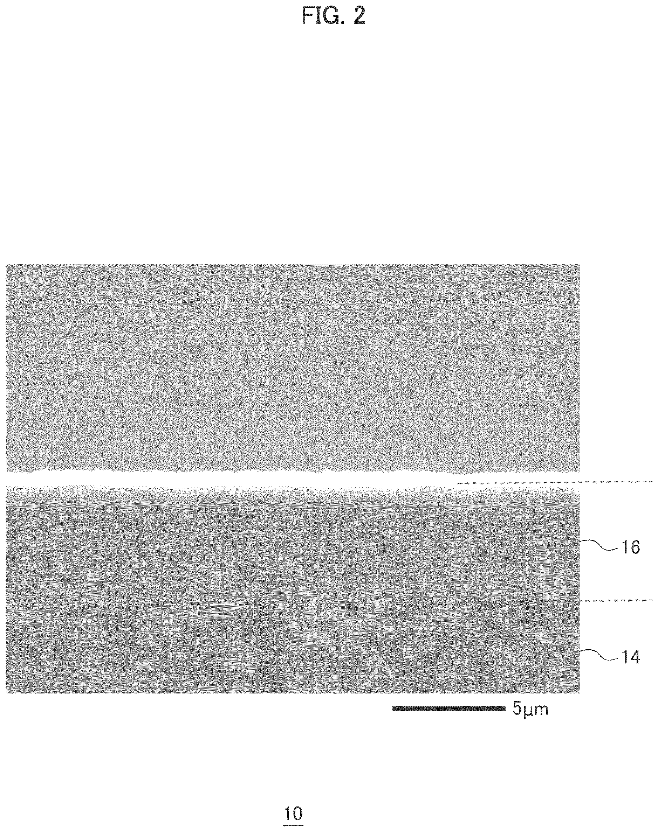

Next, characteristics of the wafer support according to each of Examples and Comparative Examples will be described. The contents of the ceramic components and the sintering aid components in each Example and each Comparative Example are as shown in Table 1. The film thickness was measured from a sectional photograph taken with a scanning electron microscope. FIG. 2 is a view showing a photograph of a section of a wafer support according to Example 1 taken with a scanning electron microscope (SEM). The protective layer 16 shown in FIG. 2 is a 5 µm-thick aluminum nitride film formed with a reactive sputtering method. As shown in FIG. 2, the protective layer 16 according to Example 1 is a dense film with no void.

**[Table 1]**

| | Base material | | | | | | | Protective film to plasma | |
|---|---|---|---|---|---|---|---|---|---|
| | Ceramic components (100 mass%) | | | | Sintering aid component (+α mass%) | | | Material | Film thickness |
| | BN | ZrO₂ | Si₃N₄ | SiC | Y₂O₃ | Al₂O₃ | MgO | | (µm) |
| Example 1 | 40.0 | 0.0 | 35.0 | 25.0 | 5.0 | 0.0 | 4.0 | AlN | 5.0 |
| Example 2 | 40.0 | 0.0 | 35.0 | 25.0 | 5.0 | 0.0 | 4.0 | Y₂O₃ | 20.0 |
| Example 3 | 65.0 | 20.0 | 0.0 | 15.0 | 10.0 | 5.0 | 3.0 | AlN | 1.5 |
| Example 4 | 65.0 | 20.0 | 0.0 | 15.0 | 10.0 | 5.0 | 3.0 | Al₂O₃ | 10.0 |
| Example 5 | 20.0 | 45.0 | 35.0 | 0.0 | 4.0 | 2.0 | 0.0 | MgO | 5.0 |
| Example 6 | 20.0 | 45.0 | 35.0 | 0.0 | 6.0 | 2.0 | 0.0 | Y₂O₃ | 3.2 |
| Comparative Example 1 | 40.0 | 0.0 | 35.0 | 25.0 | 5.0 | 0.0 | 4.0 | Protective film is absent | |
| Comparative Example 2 | 65.0 | 20.0 | 0.0 | 15.0 | 10.0 | 5.0 | 3.0 | Protective film is absent | |
| Comparative Example 3 | 20.0 | 45.0 | 35.0 | 0.0 | 4.0 | 2.0 | 0.0 | Protective film is absent | |

Table 2 shows the sample surface characteristics and the results of the plasma exposure test of the wafer support according to each of Examples 1 to 6 and Comparative Examples 1 to 3.

**[Table 2]**

| | Sample surface characteristics | | | After plasma exposure test | | |
|---|---|---|---|---|---|---|
| | Arithmetic mean height Sa | Arithmetic mean roughness Ra | Vickers hardness | Arithmetic mean height Sa | Arithmetic mean roughness Ra | Corrosion amount (level difference) |
| | (µm) | (µm) | (GPa) | (µm) | (µm) | (µm) |
| Example 1 | 0.082 | 0.08 | 11.2 | 0.080 | 0.08 | 0.0 |
| Example 2 | 0.133 | 0.13 | 5.6 | 0.142 | 0.12 | 0.0 |
| Example 3 | 0.109 | 0.08 | 10.6 | 0.115 | 0.08 | 0.0 |
| Example 4 | 0.154 | 0.10 | 10.4 | 0.146 | 0.11 | 0.0 |
| Example 5 | 0.075 | 0.05 | 4.0 | 0.077 | 0.06 | 0.0 |
| Example 6 | 0.072 | 0.06 | 4.7 | 0.072 | 0.06 | 0.0 |
| Comparative Example 1 | 0.116 | 0.05 | 4.4 | 0.311 | 0.34 | 5.4 |
| Comparative Example 2 | 0.123 | 0.08 | 1.7 | 0.354 | 0.33 | 4.0 |
| Comparative Example 3 | 0.077 | 0.05 | 8.0 | 0.323 | 0.44 | 4.4 |

### (Sample Surface Characteristics)

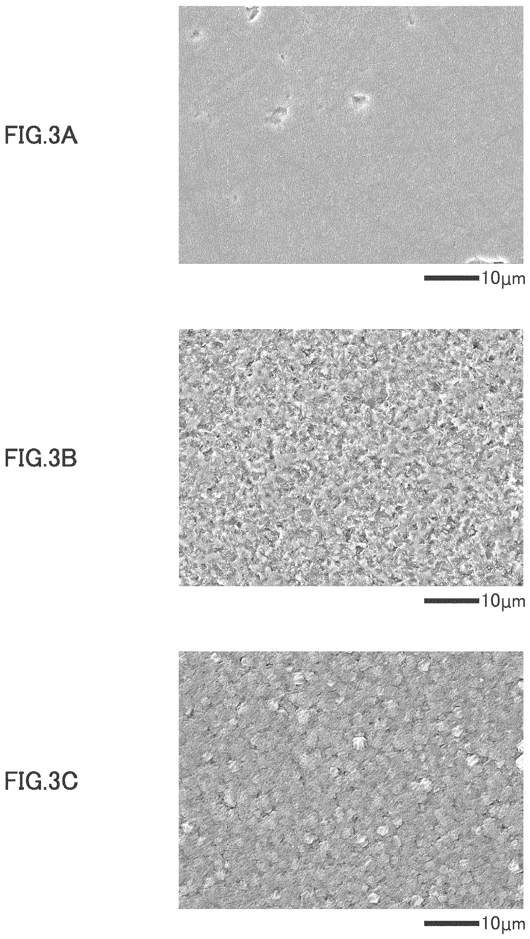

FIG. 3A is a view showing a SEM photograph of a surface of a substrate of aluminum nitride, FIG. 3B is a view showing a SEM photograph of a surface of a substrate of a machinable ceramic, and FIG. 3C is a view showing a SEM photograph of a surface of a protective layer of a wafer support according to Example 1. As the state of the sample surface, the arithmetic mean roughness Ra specified in JIS B 0601 was measured. As another state of the sample surface, the arithmetic mean height Sa specified in ISO 25178 was measured with a confocal microscope VK-X1050 manufactured by KEYENCE CORPORATION. In Examples 1 to 6, the surface of the protective layer was measured, and in Comparative Examples 1 to 3, the surface of the base material, which is a sintered body, was measured.

The surface of the base material of aluminum nitride shown in FIG. 3A has Ra of 0.05 um and Sa of 0.061 um. Meanwhile, the surface of the base material of the machinable ceramic including boron nitride shown in FIG. 3B has Ra of 0.05 um and Sa of 0.116 um, and the surface of the protective layer of the wafer support according to Example 1 shown in FIG. 3C has Ra of 0.08 um and Sa of 0.082 um. That is, at least in the case of the base material of the machinable ceramic, the arithmetic mean height Sa is larger and the contact area with the wafer is smaller than in the case of the base material of aluminum nitride, regardless of the presence or absence of the protective layer. As a result, as described above, particles generated from the wafer support can be reduced. The protective layer according to the present embodiment is to have an arithmetic mean height Sa in the range of 0.07 to 0.20 um. As a result, the protective layer can appropriately contact with the wafer to be supported.

### (Plasma Exposure Test)

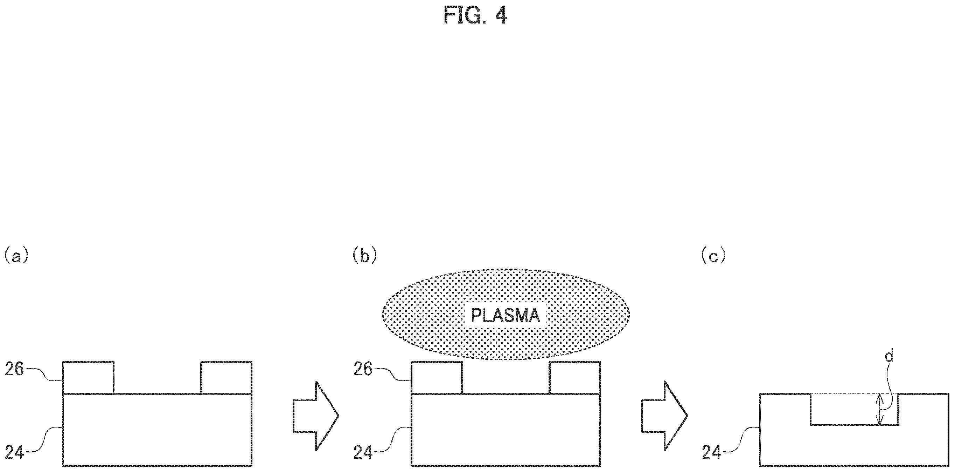

FIG. 4 is a schematic diagram for explanation of a plasma exposure test. The plasma generator used in the test is RIE-10N manufactured by Samco Inc. The plasma output is 100 W, and the kind of the gas is a mixture of 40 sccm of CF₄ and 10 sccm of O₂. The pressure is 40 Pa, and the treatment time is 240 minutes (30 minutes × 8 times). As illustrated in (a) in FIG. 4, a mask 26 such as a Kapton tape is attached to a part of a sample 24 to be tested imitating a wafer support, and as illustrated in (b) in FIG. 4, plasma treatment is performed. The mask 26 was removed after a predetermined treatment time, and the level difference d between a place not covered with the mask 26 and a place covered with the mask 26 was measured as a corrosion amount (see (c) in FIG. 4).

As shown in Table 2, in the wafer supports according to Examples 1 to 6, the level difference d was 0 um, and corrosion was not confirmed. Meanwhile, in all of the wafer supports according to Comparative Examples 1 to 3 having no protective film, the level difference d was 4 µm or more. Furthermore, in all of the wafer supports according to Examples 1 to 6, the amount of increase in the value of the arithmetic mean height Sa indicating the surface roughness after the plasma exposure test is smaller than in the wafer supports according to Comparative Examples 1 to 3. That is, the plasma resistance is higher as the corrosion amount (level difference) is smaller and the surface roughness (arithmetic mean height) is smaller, and thus the usefulness of the protective layer in the wafer support according to the present embodiment has become clear.

### (Vickers Hardness)

The corrosion resistance to plasma may be affected by physical etching in addition to etching by a chemical reaction described above. The corrosion resistance to a chemical reaction is improved, for example, by using a material including a substance that is less likely to sublimate even when reacted with plasma in which a fluorine-based (CF₄) gas is used (such as aluminum or yttrium) as the protective layer. In addition, a protective layer having a high hardness so as to be resistant to physical impact is expected to have further high corrosion resistance to plasma.

Therefore, the inventors of the present application focused on the film hardness of the protective layer. The film hardness was obtained by measuring the nanoindentation hardness H_IT by a nanoindentation method and converting the nanoindentation hardness H_IT into the Vickers hardness (GPa). For example, the wafer supports according to Examples 1, 3, and 4 have a Vickers hardness of 10 GPa or more, and are expected to have further high corrosion resistance to plasma with consideration of the results of the corrosion amount by the plasma exposure test. Meanwhile, in the case of a wafer support having a small Vickers hardness like the wafer support according to Comparative Example 2, the wafer support may be damaged at the time of packaging or assembling to an apparatus, and generation of particles may be caused.

### (Purity of Material Included in Protective Layer)

In a Johnsen-Rahbek (J-R) type electrostatic chuck, the volume resistivity of the ceramic in the wafer support needs to be controlled to about 10⁹ Qcm. An electrostatic chuck for film formation (PVD, CVD) has a high operating temperature range of to 500°C, but the resistivity of a general insulating ceramic decreases as the temperature increases. Therefore, a ceramic having a different resistivity is used for each operating temperature range.

In order to change the resistivity, an additive is often added, and for example, silicon carbide, carbon (C), titanium oxide (TiO₂), and the like are mixed with aluminum nitride by about several percents to several tens percents. However, these additives may reduce corrosion resistance to plasma or cause non-uniform etching (corrosion), and thus particles may be generated.

Therefore, in the wafer support according to the present embodiment, the volume resistivity is controlled in the base material, and in addition, the protective layer covering the surface of the base material is made to include a material having a high purity, and thus the influence of an additive in the protective layer is reduced. For example, as in the wafer support according to Example 1 or Example 3, high-purity aluminum nitride may be included as a protective layer. The protective layer is to include 99.0% or more, and more preferably 99.5% or more of aluminum nitride. As a result, original corrosion resistance of aluminum nitride to plasma can be obtained. Preparation of high-purity aluminum nitride by sputtering can be realized by forming a film using a high-purity aluminum metal and a high-purity N₂ gas in a vacuum atmosphere with little impurity contamination.

### (Thickness of Protective Layer)

In an electrostatic chuck for film formation, particularly an electrostatic chuck with a heater for CVD, the treatment temperature (heater temperature) is as high as to 500°C. For example, when a wafer at room temperature (25°C) is conveyed to such a high-temperature electrostatic chuck, a thermal shock of Δ475°C is applied. Meanwhile, the aluminum nitride ceramic has thermal shock resistance to about Δ400°C, and therefore in the case of an electrostatic chuck including only a base material containing aluminum nitride as a main component, damage to the ceramic may occur.

Meanwhile, in the case of a wafer support including a base material including a machinable ceramic like the wafer support according to the present embodiment, the thermal shock resistance is excellent. In addition, even if the protective layer covering the surface of the base material includes a material, such as aluminum nitride, aluminum oxide, yttrium oxide, or YAG, having thermal shock resistance not as high as that of the machinable ceramic, the thermal shock resistance is not impaired as long as the protective layer is a thin film of about 1 to 30 um. Furthermore, in an electrostatic chuck including a base material made of a machinable ceramic, anisotropy of thermal conductivity is obtained, and the anisotropy obtained in the base material is not impaired if the protective layer is a thin film.

Although the present invention is described above with reference to the above-described embodiments and Examples, the present invention is not limited to the above-described embodiments, and embodiments obtained by appropriately combining or replacing the configurations of the embodiments are also included in the present invention. Furthermore, it is also possible to appropriately change combinations and the order of steps in the embodiments and to add modifications such as various design changes to the embodiments on the basis of knowledge of those skilled in the art, and embodiments to which such modifications are added can also be included in the scope of the present invention.

### Industrial Applicability

The present invention can be used for an electrostatic chuck.

### Reference Signs List

- 10: Wafer support
- 12: Chamber
- 14: Base material
- 14a: Surface
- 16: Protective layer
- 16a: Mounting surface
- 18: Conductive member
- 20: Conductive member
- 22: Gas inlet
- 24: Sample
- 26: Mask
- W: Wafer

## Claims

1. A wafer support comprising: a base material including a machinable ceramic; a protective layer covering a surface of the base material; and a conductive member placed at least partially inside the base material,
the protective layer including a material that is less corrodible by plasma than the base material.

2. The wafer support according to claim 1, wherein the protective layer includes at least one material selected from the group consisting of aluminum nitride, aluminum oxide, yttrium oxide, magnesium oxide, yttrium aluminum garnet (YAG: Y₃O₅Al₁₂), and yttrium aluminum monoclinic (YAM: Y₄Al₂O₉).

3. The wafer support according to claim 1 or 2, wherein the protective layer has a thickness in a range of 1 to 30 µm.

4. The wafer support according to any one of claims 1 to 3, wherein the protective layer has an arithmetic mean height Sa in a range of 0.07 to 0.20 µm.

5. The wafer support according to any one of claims 1 to 4, wherein the protective layer includes 99.0% or more of aluminum nitride.

6. The wafer support according to any one of claims 1 to 5, wherein the machinable ceramic is a sintered body that includes at least two materials selected from the group consisting of boron nitride, zirconium oxide, silicon nitride, and silicon carbide and essentially includes boron nitride.

7. The wafer support according to claim 6, wherein
the machinable ceramic includes 10 to 80 mass% of boron nitride, 0 to 80 mass% of silicon nitride, 0 to 80 mass% of zirconium oxide, and 0 to 40 mass% of silicon carbide with respect to 100 mass% of a total of ceramic components of boron nitride, zirconium oxide, silicon nitride, and silicon carbide, and
further includes 3 to 25 mass% of a sintering aid component with respect to 100 mass% of the total of the ceramic components.

8. The wafer support according to any one of claims 1 to 7, wherein the conductive member includes a metal material selected from the group consisting of molybdenum, tungsten, tantalum, and alloys containing molybdenum, tungsten, and tantalum.
